Europäisches Patentamt

European Patent Office

Office européen des brevets

(19)

(11) Veröffentlichungsnummer: **0 193 040**
**B1**

(12) # EUROPÄISCHE PATENTSCHRIFT

(45) Veröffentlichungstag der Patentschrift:
27.12.89

(21) Anmeldenummer: 86101859.6

(22) Anmeldetag: 13.02.86

(51) Int. Cl.⁴: **G 01 R 29/027,** G 01 R 19/00,
G 01 R 29/00

(54) **Verfahren und Einrichtung zur Signalanalyse.**

(30) Priorität: 27.02.85 DE 3506984

(43) Veröffentlichungstag der Anmeldung:
03.09.86 Patentblatt 86/36

(45) Bekanntmachung des Hinweises auf die Patenterteilung:
27.12.89 Patentblatt 89/52

(84) Benannte Vertragsstaaten:
BE DE FR GB IT NL SE

(56) Entgegenhaltungen:
GB-A-1 113 883
US-A-3 898 481

(73) Patentinhaber: Siemens Aktiengesellschaft,
Wittelsbacherplatz 2, D-8000 München 2 (DE)

(72) Erfinder: Franze, Klaus, Dipl.- Ing. (FH),
Oedenbergerstrasse 154, D-8500 Nürnberg 20 (DE)

EP 0 193 040 B1

## Beschreibung

Die Erfindung betrifft ein Verfahren zur Signal-analyse, wobei ein charakteristischer Verlauf eines Signales erkannt und bei Übereinstimmung mit einem vorgegebenen Verlauf eine Meldung abgegeben wird.

In der Meß- und Prüftechnik müssen oft Signale, die einen charakteristischen Verlauf haben, analysiert und erkannt werden. Um diese Aufgabe zu lösen, ist es bisher üblich, daß das zu analysierende analoge Signal laufend digitalisiert und dann einer Auswerteeinheit zugeführt wird, wo ein Vergleich mit einem vorgegebenen Signalverlauf erfolgen kann.

Ein Verfahren und eine Einrichtung zum Vergleich eines Signales mit einem vorgegebenen Verlauf ist aus der DE-B-2 637 397 bekannt. Dabei werden sogenannte Augenblickswerte miteinander verglichen. Das sind Amplitudenwerte der beiden zu vergleichenden Signale, die zum gleichen Zeitpunkt ermittelt werden.

Ein derartiges Verfahren ist sehr aufwendig, insbesondere falls schnelle Signale mit hoher Auflösung analysiert und verglichen werden sollen. Dann ist nämlich ein hoher Datenstrom kurzzeitig zu bewältigen, was eine umfangreiche Elektronik erfordert.

Der Erfindung liegt die Aufgabe zugrunde, ein Verfahren und eine Einrichtung zur Signalanalyse zu entwickeln, die es gestattet, mit einfachen elektronischen Mitteln charakteristische Merkmale eines Signales mit hoher Genauigkeit und ohne Totzeiten zu erkennen. Ein Vergleich von zwei Signalen soll dann nur durch einen Vergleich dieser charakteristischen Merkmale schnell und zuverlässig durchführbar sein.

Ein Gerät zur Analyse eines elektrischen Signales ist aus der GB-A-1 113 883 bekannt. Mit diesem Gerät sind die Bereiche eines Signales mit positiver Steigung und die Bereiche mit negativer Steigung zu identifizieren. Es wird dadurch annähernd die Lage der Extrema des Signalverlaufes bestimmt. Falls ein Signal nur wenige Extrema aufweist, ist die Meßgenauigkeit einer derartigen Signalanalyse gering. Eine Steigerung der Meßgenauigkeit im Einzelfall ist nicht möglich.

Aus der US-A-3 898 481 ist ein Detektor bekannt, mit dem Signalpulse erfaßt werden. Es wird sowohl ein Signalanstieg als auch die Pulsbreite erfaßt. Eine Charakterisierung eines Signales, das nur wenige scharfe Pulse aufweist, ist mit diesem Detektor nur ungenau möglich. Eine Steigerung der Meßgenauigkeit ist im Einzelfall auch mit diesem Detektor nicht durchführbar.

Die der vorliegenden Erfindung zugrunde liegende Aufgabe, ein Verfahren und eine Einrichtung zur Signalanalyse zu entwickeln, wobei charakteristische Merkmale mit hoher Genauigkeit und ohne Totzeiten erkannt werden können, wird erfindungsgemäß dadurch gelöst, daß Ordinatenwerte des Signales in bestimmten zeitlichen Abständen registriert werden und daß jeweils zwei zeitlich benachbarte Ordinatenwerte miteinander verglichen werden, wobei durch die Abfolge der Vergleichswerte das Signal charakterisiert wird, und daß die Abfolge der Vergleichswerte mit einer vorgegebenen Abfolge von Vergleichswerten verglichen wird und bei Übereinstimmung eine Meldung abgegeben wird.

Beispielsweise wird das Signal durch die Abfolge der Vorzeichen von Differenzen zeitlich benachbarter Ordinatenwerte charakterisiert. Positive Vorzeichen belegen hierbei eindeutig eine positive bzw. negative Steigung der Signalfunktion. Entsprechend zeigen negative Vorzeichen eine negative bzw. positive Steigung an und ein Vorzeichenwechsel läßt einen Extremwert erkennen. In Verbindung mit den bekannten zeitlichen Abständen von zwei benachbarten Ordinatenwerten ermöglicht das erfindungsgemäße Verfahren, daß auch andere Merkmale des Signales, wie Sattelpunkte und Plateaus erkannt werden. Selbst die Frequenz eines periodischen Signales kann bestimmt werden, indem beispielsweise die Zahl der Zeitspannen zwischen den Maxima bestimmt wird. Der gewählte zeitliche Abstand zwischen zwei benachbarten gemessenen Ordinatenwerten ist ein Maß für die Meßgenauigkeit des erfindungsgemäßen Verfahrens.

Nach einem anderen Beispiel wird das Signal durch die Abfolge der Ordinatenwertdifferenzen charakterisiert, die dann auch die Steilheit der Signalfunktion belegt.

Mit der Erfindung wird der Vorteil erzielt, daß die Meßgenauigkeit der Signalanalyse stets von den Erfordernissen angepaßt und dadurch das Verfahren beschleunigt werden kann. Falls die Anforderungen nicht extrem hoch sind, kommt man erfindungsgemäß für die Signalanalyse mit wenigen Meßwerten und daher mit wenigen, einfachen Bauteilen aus.

Nach dem ersten Beispiel ist vorgesehen, daß die Abfolge der Vorzeichen als Bitmuster dargestellt, in einem Logikteil mit einem vorgegebenen Bitmuster verglichen und bei Übereinstimmung ein Signal abgegeben wird. Ein positives Vorzeichen wird dabei durch einen Impuls (Eins) und ein negatives Vorzeichen durch eine Pause (Null) dargestellt. Ein derartiges Bitmuster kann leicht ausgewertet werden.

Soll beispielsweise ein Signalverlauf mit einem vorgegebenen Verlauf verglichen werden, dann wird nach der Erfindung im Logikteil das vorgegebene Bitmuster mit dem gemessenen Bitmuster verglichen.

Auch die Abfolge von Ordinatenwertdifferenzen nach dem zweiten Beispiel wird in einem Vergleichsteil mit vorgegebenen Werten verglichen.

Bei einer Einrichtung zur Durchführung des erfindungsgemäßen Verfahrens ist ein Eingang für ein analoges Signal mit mehreren in Serie geschalteten Verzögerungsgliedern verbunden. Parallel zu jedem Verzögerungsglied ist jeweils ein Differenzverstärker angeordnet, der zwei zeitlich benachbarte Ordinatenwerte des Signales zur Charakterisierung des analogen Signales miteinander vergleicht. An den Ausgängen der Differenzverstärker steht die Abfolge der Vergleichs-

3

werte an. Die Ausgänge der Differenzverstärker sind mit einem Logikteil oder Vergleichsteil verbunden, das eine vorgegebene Abfolge von Vergleichswerten enthält. Im Logikteil oder Vergleichsteil ist ein Vergleich der charakterisierenden Abfolge mit der vorgegebenen Abfolge von Vergleichswerten durchführbar. Das Vergleichsteil ist mit einer Auswerteeinheit zur Abgabe einer Meldung bei Übereinstimmung der beiden Abfolgen verbunden.

In jedem Verzögerungsglied wird das eingespeiste Signal um eine bekannte Zeitspanne verzögert. Derjenige Differenzverstärker, der parallel zu einem bestimmten Verzögerungsglied angeordnet ist, vergleicht den hinter dem Verzögerungsglied abgegriffenen Wert mit dem Wert vor dem Verzögerungsglied. Es werden also zwei Ordinatenwerte miteinander verglichen, die in einem der Verzögerungszeit entsprechenden zeitlichen Abstand bestimmt wurden. Ein als Komparator geschalteter Differenzverstärker gibt dann bei steigendem Ordinatenwert ein Eins- bzw. Null-Signal und bei fallendem Ordinatenwert ein Null- bzw. Eins-Signal an seinem Ausgang ab.

Mit der Erfindung wird der Vorteil erzielt, daß ein Signalverlauf durch ein Bitmuster charakterisierbar ist, das mit einfachen Mitteln schnell erzeugt werden kann.

Darüber hinaus kann in einem Logikteil das anstehende Bitmuster mit einem vorgegebenen Bitmuster verglichen und bei Übereinstimmung eine Auswerteeinheit aktiviert werden. Hiermit wird der Vorteil erzielt, daß aus einer großen Anzahl von Signalen genau diejenigen ausgewählt werden, deren Verlauf dem vorgegebenen charakteristischen Verlauf entspricht. Dabei hängt die Genauigkeit des Vergleiches von der Anzahl der Vergleichswerte ab. In der Regel reicht es aus, wann Bitmuster sowie Vergleichsmuster relativ wenig Werte enthalten. Man kommt dann mit einer eng begrenzten Zahl elektronischer Bauteile, wie Verzögerungsglieder und Komparatoren aus.

Bei Bedarf kann jedoch die Signalanalyse noch empfindlicher mit größerer Auflösung durchgeführt werden. Dazu muß nur die Anzahl der Bits im Bitmuster wie auch im Vergleichsmuster vergrößert werden, indem beispielsweise die Zahl der Verzögerungsglieder erhöht oder die Verzögerungszeit eines jeden Verzögerungsgliedes verkürzt wird. Die Signalanalyse nach der Erfindung kann also mit einer beliebiger Genauigkeit durchgeführt werden.

Beispielsweise kann auch vorgesehen sein, daß eine abgezählte Anzahl der Komparatorausgänge miteinander verbunden ist, wodurch eine Wichtung erfolgt. Dadurch bleiben vereinzelt mögliche Fehlmessungen unberücksichtigt und beeinflussen nicht das Bitmuster, das von den Komparatoren an den Logikteil abgegeben wird.

Weiterhin kann mit einem Eingang des Logikteiles der Ausgang eines weiteren Komparators verbunden sein, dessen einer Eingang mit dem zu analysierenden Signal beaufschlagt ist und dessen anderer Eingang mit einer variablen

4

Spannungsquelle zum Erzeugen einer Schwellenspannung verbunden ist. Mit dieser Einrichtung wird erreicht, daß diejenigen Anteile des Signales bei der Analyse unberücksichtigt bleiben, deren Potential kleiner ist als die vorgegebene Schwellenspannung. Diese wird so gewählt, daß das apparative Rauschen vor und nach dem Eintreffen eines Signals abgeschnitten wird. Die Signalanalyse nach der Erfindung bleibt dadurch vorteilhaft von äußeren Störeinflüssen frei.

Die Zuleitungen zu den Eingängen des weiteren Komparators können auch vertauscht angeschlossen sein. Dann wird erreicht, daß diejenigen Anteile des Signals bei der Analyse unberücksichtigt bleiben, deren Potential größer ist als die Schwellenspannung. Dadurch werden unerwünschte große Signale, die systembedingt sind, abgeschnitten.

Die Komparatoren können auch beispielsweise durch ihre äußere Beschaltung nach Art einer Hysterese schalten. Dadurch wird der Verlauf des Signals noch genauer analysiert.

Mit der Erfindung wird insbesondere der Vorteil erzielt, daß ein beliebiges Signal mit kleinem apparativen Aufwand ausreichend genau analysiert werden kann und so ein charakteristischer Verlauf sicher zu erkennen ist.

Die Erfindung soll anhand eines in der Zeichnung schematisch wiedergegebenen Ausführungsbeispiels näher erläutert werden:

Fig. 1    zeigt eine Einrichtung zur Durchführung des erfindungsgemäßen Signalanalyseverfahrens.

Fig. 2    zeigt den Verlauf eines zu analysierenden Signales.

Fig. 3    zeigt eine Schaltungsanordnung zum Erzielen einer Wichtung der Meßwerte.

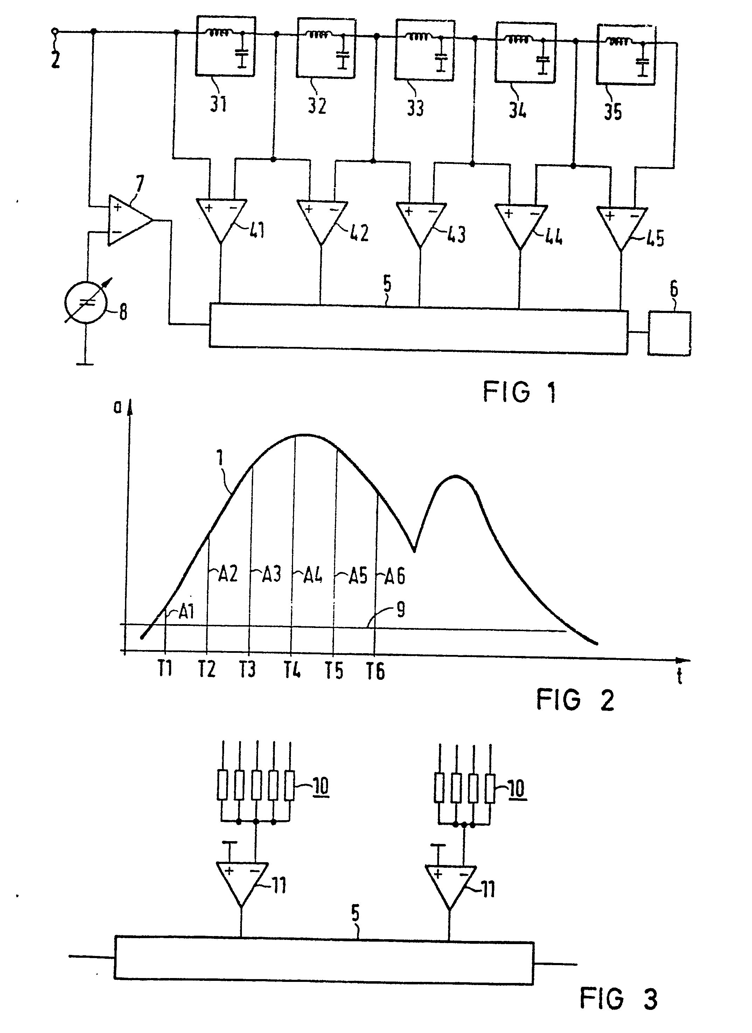

Einer Einrichtung zur Signalanalyse nach Fig. 1 wird ein zu analysierendes Signal nach Fig. 2 an einem Eingang 2 zugeführt. Der Eingang 2 ist mit einer Anzahl in Serie geschalteter, gleichartiger Verzögerungsglieder 31 bis 35 verbunden, wodurch in zeitlich gleichen Abständen in den Zeitpunkten $T_1$ bis $T_6$ Ordinatenwerte $A_1$ bis $A_6$ des Signals 1 abgegriffen werden. Dabei wächst die Genauigkeit der Analyse mit der Zahl der Verzögerungsglieder. Alle Verzögerungsglieder 31 bis 35 sind in bekannter Weise aus ohmschem Widerstand und Kondensator aufgebaut.

Parallel zu jedem Verzögerungsglied 31 bis 35 ist jeweils ein Komparator 41 bis 45 angeordnet. Der Komparator 42 beispielsweise vergleicht dann den Ordinatenwert $A_2$ im Zeitpunkt $T_2$ mit dem Ordinatenwert $A_3$ im Zeitpunkt $T_3$; man vergleiche Fig. 2. Entsprechend werden durch die Einrichtung alle zeitlich benachbarten Ordinatenwerte miteinander verglichen. Falls beispielsweise der Ordinatenwert $A_3$ größer ist als der Ordinatenwert $A_2$, steht am Ausgang des Komparators 42 ein Eins-Signal an. Falls der Ordinatenwert $A_5$ kleiner ist als der Ordinatenwert $A_4$, steht

# EP 0 193 040 B1

5

am Ausgang des Komparators 44 ein Null-Signal an. Die Ausgänge der Komparatoren 41 bis 45 sind mit einem Logikteil 5 verbunden, dem die Komparatoren 41 bis 45 ein Bitmuster zuführen, das den Verlauf des Signales 1 charakterisiert. Im Logikteil 5 wird dann das gemessene Bitmuster mit einem vorgegebenen Bitmuster verglichen und falls die beiden Bitmuster übereinstimmen, eine Auswerteeinheit 6 aktiviert, die mit dem Logikteil 5 verbunden ist. Dadurch werden aus vorhandenen Signalen diejenigen ausgewählt, die einen vorgegebenen charakteristischen Verlauf haben.

Das Logikteil 5 ist außerdem mit einem weiteren Komparator 7 verbunden, dessen erster Eingang mit dem zu analysierenden Signal 1 beaufschlagt ist und dessen zweiter Eingang mit einer variablen Spannungsquelle 8 verbunden ist. Dadurch wird das Logikteil 5 erst dann aktiviert, wenn das zu analysierende Signal 1 eine Schwellenspannung 9 nach Fig. 2 übersteigt. Diese Schwellenspannung 9 wird mit der variablen Spannungsquelle 8 so gewählt, daß Störimpulse mit niedriger Amplitude ohne Einfluß bleiben.

Damit einzelne Fehlmessungen unberücksichtigt bleiben, ist nach Fig. 3 eine Wichtung vorgesehen. Dazu sind die Komparatoren 41 bis 45 in einzelne Gruppen zusammengefaßt und in jeder Gruppe sind die Ausgänge der Komparatoren über ohmsche Widerstände 10 miteinander verbunden.

So ergibt sich für jede Gruppe ein gemeinsamer Ausgang, der über einen Komparator 11 mit dem Logikteil 5 verbunden ist.

Die Meßgenauigkeit der Signalanalyse kann durch die Anzahl der Verzögerungsglieder wie auch durch die Wahl der Verzögerungszeit variiert werden.

## Patentansprüche

1. Verfahren zur Signalanalyse, wobei ein charakteristischer Verlauf eines Signales (1) erkannt und bei Übereinstimmung mit einem vorgegebenen Verlauf eine Meldung abgegeben wird, *dadurch gekennzeichnet*, daß Ordinatenwerte ($A_1$ bis $A_6$) des Signales (1) *in* bestimmten zeitlichen Abständen registriert werden und daß jeweils zwei zeitlich benachbarte Ordinatenwerte ($A_1$ bis $A_6$) miteinander verglichen werden, wobei durch die Abfolge der Vergleichswerte das Signal (1) charakterisiert wird, und daß die Abfolge der Vergleichswerte mit einer vorgegebenen Abfolge von Vergleichswerten verglichen wird und bei Übereinstimmung eine Meldung abgegeben wird.

2. Verfahren nach Anspruch 1, *dadurch gekennzeichnet*, daß durch die Abfolge der Differenzen von jeweils zwei zeitlich benachbarten Ordinatenwerten ($A_1$ bis $A_6$) das Signal (1) charakterisiert wird.

3. Verfahren nach Anspruch 1, *dadurch gekennzeichnet*, daß durch die Abfolge der Vorzeichen der Differenzen von jeweils zwei zeitlich benachbarten Ordinatenwerten ($A_1$ bis $A_6$) das Signal (1) charakterisiert wird, die Abfolge der Vorzeichen als Bitmuster dargestellt in einem Logikteil (5) mit einem vorgegebenen Bitmuster verglichen wird und bei Übereinstimmung ein Signal abgegeben wird.

4. Einrichtung zur Durchführung des Verfahrens nach den Ansprüchen 1 und 2, *dadurch gekennzeichnet*, daß ein Eingang (2) für ein analoges Signal (1) mit in Serie geschalteten Verzögerungsgliedern (31 bis 35) verbunden ist, daß parallel zu jedem Verzögerungsglied (31 bis 35) jeweils ein Differenzverstärker angeordnet ist, der zwei zeitlich benachbarte Ordinatenwerte ($A_1$ bis $A_6$) des Signales (1) zur Charakterisierung des analogen Signales (1) miteinander vergleicht, wobei an den Ausgängen der Differenzverstärker die Abfolge der Vergleichswerte ansteht, und daß die Ausgänge der Differenzverstärker mit einem Vergleichsteil, das eine vorgegebene Abfolge von Vergleichswerten enthält, verbunden sind, zum Vergleich der charakterisierenden Abfolge mit der vorgegebenen Abfolge und daß das Vergleichsteil mit einer Auswerteeinheit (6) verbunden ist, zur Abgabe einer Meldung bei Übereinstimmung der beiden Abfolgen.

5. Einrichtung nach Anspruch 4, zur Durchführung das Verfahrens nach den Ansprüchen 1 und 3, *dadurch gekennzeichnet*, daß die Differenzverstärker als Komparatoren (41 bis 45) geschaltet sind und daß die Ausgänge der Komparatoren (41 bis 45) mit einem Logikteil (5) verbunden sind, mit dessen Ausgang eine Auswerteeinheit (6) in Verbindung steht.

6. Einrichtung nach Anspruch 5, *dadurch gekennzeichnet*, daß eine abgezählte Anzahl der Komparatorausgänge miteinander verbunden ist, wodurch eine Wichtung erfolgt.

7. Einrichtung nach Anspruch 5, *dadurch gekennzeichnet*, daß mit einem Eingang des Logikteils (5) der Ausgang eines weiteren Komparator (7) verbunden ist, dessen einer Eingang mit dem zu analysierenden Signal (1) beaufschlagt ist und dessen anderer Eingang mit einer variablen Spannungsquelle (8) zur Erzeugung einer Schwellenspannung (9) verbunden ist.

8. Einrichtung nach Anspruch 5, *dadurch gekennzeichnet*, daß die Komparatoren (41 bis 45) nach Art einer Hysterese schalten.

## Claims

1. A method for signal analysis, wherein a characteristic pattern of a signal (1) is recognised and a signal is transmitted if the said pattern corresponds to a given pattern *characterised in that* the ordinate values (A1 to A6) of the signal (1) are recorded at specific intervals in time and in that each pair of successive ordinate values (A1 to A6) are compared with one another, with the signal (1) being characterised by the sequence of comparative values, and in that the sequence of comparative values is compared with a given sequence of comparative values and a signal is transmitted if the said values correspond.

2. A method according to claim 1, *characterised in that* the signal (1) is characterised by the sequence of the differences of each pair of successive ordinate values (A1 to A6).

3. A method according to claim 1, *characterised in that* the signal (1) is characterised by the sequence of the signs of the differences of two successive ordinate values (A1 to A6) in each case, the sequence of the signs being represented as a bit pattern and compared in a computing unit (5) with a given bit pattern and a signal being transmitted if the said patterns correspond.

4. A device for carrying out the method according to claims 1 and 2, *characterised in that* an input (2) for an analog signal (1) is connected with delay elements (31 to 35) connected in series, in that a differential amplifier is arranged in parallel with each delay element (31 to 35) and compares two successive ordinate values (A1 to A6) of the signal (1) in order to characterise the analog signal (1), the sequence of comparative values being produced at the outputs of the differential amplifiers, and in that the outputs of the differential amplifiers are connected with a comparing unit, which contains a given sequence of comparative values, in order to compare the characterising sequence with the given sequence and in that the comparing unit is connected with an evaluation unit (6) for transmitting a signal if the two sequences correspond.

5. A device according to claim 4, for carrying out the method according to claims 1 and 3, *characterised in that* the differential amplifiers are connected as comparators (41 to 45) and the outputs of the comparators (41 to 45) are connected with a computing unit (5), with whose output an evaluation unit (6) is connected.

6. A device according to claim 5, *characterised in that* a specific number of comparator outputs are connected with one another, resulting in a weighting.

7. A device according to claim 5, *characterised in that* a further comparator (7) is connected with one input of the computing unit (5), the first input of the comparator being acted upon by the signal (1) to be analysed and its other input being connected with a variable voltage source (8) for producing a threshold voltage (9).

8. A device according to claim 5, *characterised in that* the comparators (41 to 45) are connected in the manner of a hysteresis.

## Revendications

1. Procédé pour analyser des signaux, selon lequel une allure caractéristique d'un signal (1) est identifiée et, dans le cas de sa coïncidence avec une allure prédéterminée, une signalisation est délivrée, *caractérisé par le fait que* la valeur en ordonnées ($A_1$ à $A_6$) du signal (1) est enregistrée à des intervalles de temps déterminés et que respectivement deux valeurs en ordonnées ($A_1$ à $A_6$), voisines dans le temps, sont comparées l'une à l'autre, le signal (1) étant caractérisé par la suite des valeurs de comparaison, et que la suite des valeurs de comparaison est comparée à une suite prédéterminée des valeurs de comparaison et qu'en cas de coïncidence, une signalisation est délivrée.

2. Procédé suivant la revendication 1, *caractérisé par le fait que* le signal (1) est caractérisé par la suite des différences de deux valeurs respectives en ordonnées ($A_1$ à $A_6$), voisines dans le temps.

3. Procédé suivant la revendication 1, *caractérisé par le fait que* le signal (1) est caractérisé par la suite des signes des différences de deux valeurs respectives en ordonnées ($A_1$ à $A_6$) voisines dans le temps, que la suite des signes, représentée sous la forme d'un profil binaire, est comparée à un profil binaire prédéterminé, dans un circuit logique (5) et qu'en cas de coïncidence, un signal est délivré.

4. Dispositif pour la mise en oeuvre du procédé suivant les revendications 1 et 2, *caractérisé par le fait qu'*une entrée (2) pour un signal analogique (1) est reliée à des circuits de retard (31 à 35) branchés en série, qu'en parallèle avec chaque circuit de retard (31 à 35) est branché respectivement un amplificateur différentiel qui compare entre elles deux valeurs en ordonnées ($A_1$ à $A_6$), voisines dans le temps, du signal analogique (1), de manière à caractériser ce signal, la suite des valeurs de comparaison apparaissant sur les sorties des amplificateurs différentiels, et que les sorties des amplificateurs différentiels sont reliées à un circuit comparateur qui contient une suite prédéterminée de valeurs de comparaison, pour la comparaison de la suite caractérisante avec la suite prédéterminée, et que le circuit comparateur est relié à une unité d'évaluation (6), pour la délivrance d'une signalisation dans le cas d'une coïncidence des deux suites.

5. Dispositif suivant la revendication 4, pour la mise en oeuvre du procédé suivant les revendications 1 et 3, *caractérisé par le fait que* les amplificateurs différentiels sont branchés en tant que comparateurs (41 à 45), et que les sorties des comparateurs (41 à 45) sont reliées à un circuit logique (5), à la sortie duquel est raccordée une unité d'évaluation (6).

6. Dispositif suivant la revendication 5, *caracté-*

*risé par le fait qu*'un nombre compté des sorties du comparateur sont reliées entre elles, ce qui permet de réaliser une pondération.

7. Dispositif suivant la revendication 5, *caractérisé par le fait qu'à* une entrée du circuit logique (5) est raccordée la sortie d'un autre comparateur (7), dont une entrée est chargée par le signal (1) devant être analysé et dont l'autre entrée est reliée à une source de tension variable (8) servant à produire une tension de seuil (9).

8. Dispositif suivant la revendication 5, *caractérisé par le fait que* les comparateurs (41 à 45) exécutent une commutation du type à hystérèse.

FIG 1

FIG 2

FIG 3